Europäisches Patentamt

European Patent Office

Office européen des brevets

(11) Numéro de publication: **0 344 075**
**A1**

## (12) DEMANDE DE BREVET EUROPEEN

(21) Numéro de dépôt: **89420113.6**

(22) Date de dépôt: **29.03.89**

(51) Int. Cl.⁴: **H 05 K 13/08**

(30) Priorité: **30.03.88 FR 8804725**

(43) Date de publication de la demande:
**29.11.89 Bulletin 89/48**

(84) Etats contractants désignés:
**BE CH DE ES GB IT LI NL SE**

(71) Demandeur: **Morille, Robert**
**41 Rue Charles Gounod**
**F-26000 Valence (FR)**

(72) Inventeur: **Morille, Robert**
**41 Rue Charles Gounod**
**F-26000 Valence (FR)**

(74) Mandataire: **Maisonnier, Jean**
**Bureau Maisonnier 28 Rue Servient**
**F-69003 Lyon (FR)**

Le titre de l'invention a été modifié (Directives relatives à l'examen pratiqué à l'OEB, A-III, 7.3)

(54) **Contrôle de la fabrication d'un circuit imprimé.**

(57) L'invention concerne le contrôle des circuits imprimés électroniques, en fin de fabrication.

Sur le circuit A contrôler (24), on pose un circuit d'interface (26) qui lui est spécifique. Sur celui-ci, on pose et déplace par incréments successifs, un circuit explorateur standard (35) qui est relié à une électronique standard (35) avec mémoire (39).

Application : détection automatique des défauts d'isolation et des court-circuits même pour des circuits (24) multicouches et de types divers.

Fig.1

EP 0 344 075 A1

Description

# PROCEDE ET DISPOSITIF POUR LA VERIFICATION ET LE CONTROLE EN FABRICATION D'UN CIRCUIT IMPRIME

La présente invention concerne un procédé d'exploration et un dispositif destinés à permettre la vérification et le contrôle, en cours de fabrication, d'un circuit imprimé comportant des pastilles conductrices de contrôle.

On sait qu'au cours de la fabrication d'un circuit imprimé , avant d'y implanter des composants électroniques divers il est nécessaire de vérifier si toutes les connexions formées sur le circuit sont satisfaisantes , c'est-à-dire notamment :
- d'une part , s'il n'y a pas de court-circuit entre diverses connexions ;
-d'autre part , si certaines connexions ne sont pas interrompues.

Les procédés de contrôle utilisés à ce jour présentent divers inconvénients . D'une part , certains ne permettent pas de contrôler des circuits de très hautes densités D'autres obligent à prévoir , pour le contrôle , deux interfaces et deux circuits explorateurs qui sont spécifiques au circuit à vérifier .Autrement dit , le contrôleur doit disposer d'un grand nombre d'interfaces spécifiques et de circuits explorateurs communs pour les divers circuits à tester , correspondant chacun à un circuit bien déterminé , dont la fabrication est entreprise.

Enfin, la mise en oeuvre des procédés connus à ce jour est,soit relativement lente , soit limitée en ce qui concerne la densité du circuit.

La présente invention a pour but d'éviter ces inconvénients,en utilisant un procédé et un dispositif permettant de vérifier rapidement un circuit imprimé,étant entendu que ce dispositif comporte un seul circuit explorateur qu'on peut, par ailleurs,utiliser sur des circuits imprimés de types et de conformations divers,y compris des circuits de très hautes densités.

La présente invention concerne les dispositifs de contrôle qualitatif , pour des circuits imprimés complexes , et , notamment , les circuits imprimés destinés au report à plat des composants . Ces circuits , généralement très compacts , sont constitués par de multiples couches superposées en un matériau isolant , qui supportent une plus ou moins grande densité d'éléments conducteurs à vérifier.

Un dispositif de contrôle selon l'invention est caractérisé en ce qu'il comprend , en combinaison :
- un circuit palpeur spécifique , constitué par une plaque d'un matériau isolant souple , pourvu , sur ses deux faces , d'une pluralité de plots conducteurs , dont le nombre et la position correspondent à toutes les pastilles conductrices utiles de chacun des arbres accessibles par une des faces du circuit à contrôler , la liaison électrique entre chaque couple de plots conducteurs qui correspond à une pastille du circuit à contrôler , étant assurée par un trou métallisé ;
- un circuit explorateur , associé au circuit palpeur, et constitué par un film souple isolant , comportant sur une de ses faces ,une plage conductrice dont les dimensions sont suffisantes pour lui permettre de recouvrir en totalité la surface du circuit à contrôler , alors qu'est prévue une rangée de plots conducteurs à diamètre plus faible que le plus faible espace isolant qui peut se trouver entre deux pastilles contigues sur la face externe du circuit palpeur spécifique , lesdits plots étant reliés à l'électronique de détection par une nappe de pistes conductrices réalisées sur l'une des faces du circuit explorateur, le pas des plots et leur nombre étant tels que la longueur de la rangée de plots est supérieure à la plus petite dimension du circuit à contrôler , tandis que toutes les pastilles d'une rangée sont en contact avec un plot ;
- un système électronique de détection , et une mémoire , permettant , par un procédé de multiplexage , d'enregistrer l'état de conduction électrique de chaque plot par rapport à la plage conductrice et à chacun des autres plots de la rangée.

Suivant une autre caractéristique de l'invention , il est avantageux de séparer chacun des plots de circuit explorateur en deux plots élémentaires indépendants , reliés indépendamment l'un de l'autre , à l'électronique de détection : cela permet de vérifier le bon contact électrique des plots avec les pastilles du circuit d'interface avant de déclencher les mesures.

Le dessin annexé , donné à titre d'exsemple non limitatif , permettra de mieux comprendre les caractéristiques de l'invention,et les avantages qu'elle est susceptible de procurer.

Figure 1 représente , schématiquement , la coupe transversale d'un dispositif organisé pour la mise on oeuvre d'une opération de test d'un circuit imprimé multicouche .

Figure 2 est une vue partielle en plan , montrant la position respective des plots élémentaires.

Figure 3 correspond à la figure 1, dans le cas où le circuit a vérifier présente , d'une part un incident de court-circuit , d'autre part , un incident de coupure.

Figure 4 est une vue en plan , montrant un détail de la figure 3.

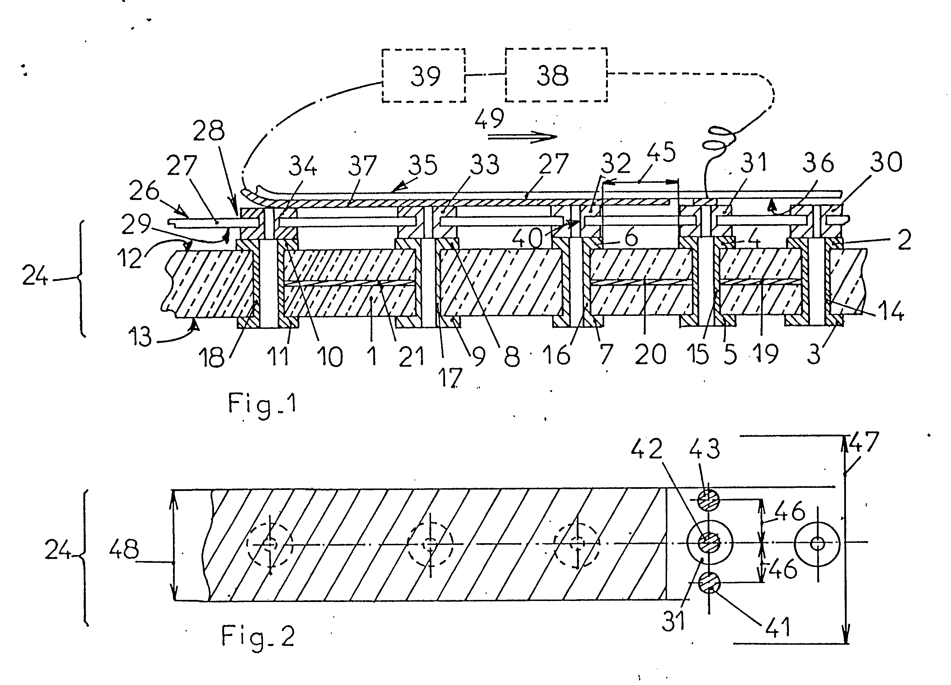

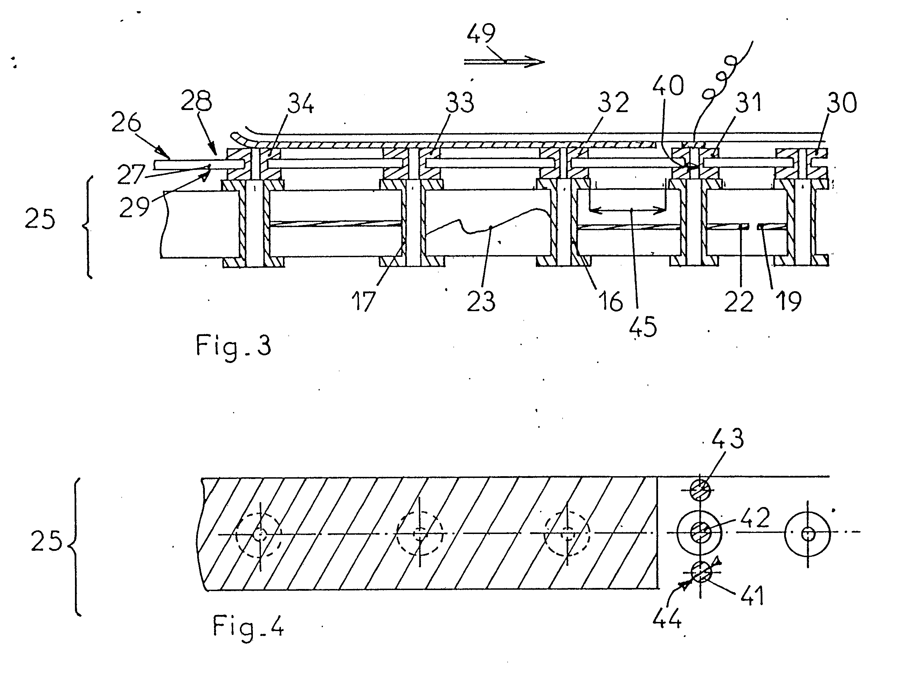

On a representé sur les Figures 1 et 3 un circuit imprimé multicouche qui comprend :
- une carte de support 1 en matière isolante ;
- des pastilles métalliques telles que 2, 4, 6, 8, 10 accesibles sur sa face 12 ;
- des pastilles métalliques telles que 3, 5, 7, 9, 11 accesibles sur sa face opposée 13 où elles sont réparties ;
- des pieds de liaison métalliques tels que 14, 15, 16,17 18 reliant deux à deux les pastilles à travers l'épaisseur de la carte isolante 1 ;
- des liaisons conductrices telles que 19, 20, 21 disposées dans l'épaisseur de la matière isolante de la carte 1 pour relier électriquement certains des pieds tels que 14, 15, 16, et 17, 18;
-des "arbres" métalliques non représentés, imprimés en surface sur les faces 12 et 13 de la carte 1 selon des tracés définis par la spécifité du circuit multicouches.

L'ensemble d'un tel circuit 1 à 21 est en lui-même connu.

L'invention vise à mettre en évidence l'existence éventuelle de défauts qui peuvent être notamment constitués :
- par une interruption intempestive 22 dans une liaison telle que 19 ;
- par un court-circuit intempestif tel que 23 entre deux connexions telles que par exemple les pieds 16 et 17.

Pour la commodité des explications, on a désigné par la référence globale 24 l'ensemble du circuit imprimé réputé "bon" qui apparaît sur les figures 1 et 2, et par la référence globale 25 le circuit défectueux de même type schématisé sur les Figures 3 et 4.

L'appareillage de contrôle selon l'invention comprend :
  1° un circuit palpeur 26 constitué par une plaque isolante souple 27 pourvue sur ses deux faces 28 et 29 d'une pluralité de plots conducteurs tels que 30, 31, 32, 33, 34 ;
  2° un circuit explorateur 35 constitué par un film souple isolant comportant sur l'une de ses faces 36, une plage conductrice 37 dont les dimensions sont suffisantes pour lui permettre de recouvrir l'ensemble du circuit imprimé 24 ou 25 à contrôler ;
  3° un système électronique de détection 38 et une mémoire 39 permettant, par un système de multiplexage, d'enregistrer l'état de conduction électrique du circuit 25 à tester, et de le comparer avec les paramètres en mémoire du circuit précédent 24, réputé "bon".

L'appareillage palpeur ou auscultateur, qui comprend le circuit explorateur 35 et l'ensemble électronique 38, 39 est standard. Autrement dit, il s'agit d'un appareillage général utilisable tel que pour tester n'importe quel type de circuit imprimé.

Par contre, le circuit palpeur 26 est spécifique, en ce sens qu'il correspond au type du circuit 24, 25 à tester. Lutilisateur doit, pour chaque type de circuit imprimé à tester, disposer du circuit palpeur 26 correspondant. Ce circuit palpeur 26 constitue l'interface spécifique entre le type de circuit 24, 25 à tester, et l'appareillage palpeur ou auscultateur 35 à 39 qui, lui, reste standard dans tous les cas.

Le nombre et la disposition des plots conducteurs 30 à 34 du circuit palpeur 26 correspondent à toutes les pastilles conductrices utiles 2 à 11 de chacun des arbres du circuit 24, 25 à tester. La liaison électrique entre chaque couple de plots conducteurs 30 à 34 est assurée par un trou métallisé tel que 40.

Le circuit explorateur 35 comporte, en avant de la plage conductrice 37, une rangée de plots conducteurs tels que 41, 42, 43 dont le diamètre 44 est plus faible que le plus faible espace isolant 45 susceptible de se trouver entre deux pastilles contigües, par exemple 4 et 6.

Ces plots 41, 42, 43 sont reliés à l'électronique de détection 38 par une nappe de pistes conductrices non représentées figurant sur l'une des faces du circuit palpeur 26. Ces plots 41 à 43 sont disposés suivant un pas 46 et en un nombre tels que la longueur 47 de la rangée de plots 41, 42, 43 etc... soit supérieure à la plus petite dimension 48 du circuit à contrôler 24,25. Par ailleurs, toutes les pastilles telles que 31 d'une même rangée sont en contact avec un plot 41, 42, 43, etc...

Le fonctionnement est le suivant :

Sur le circuit à tester 24, 25, on applique le circuit palpeur 26 dont les plots 30 à 34 se trouvent en contact avec les pastilles 2, 4, 6, 8, 10, etc..., et on le maintient immobile.

Ensuite, sur ce circuit palpeur 26, on pose le circuit explorateur 35 qu'on déplace comme indiqué par la flèche 49 en le faisant coulisser par incréments successifs, tout en gardant le contact avec le circuit palpeur 26.

Ainsi, à chaque incrément du mouvement, l'ensemble électronique 38 relève une série de paramètres sur l'état de connexion ou de non-connexion électrique entre les pastilles d'une même rangée. Cette série de paramètres est comparée avec la série standard correspondante stockée dans la mémoire 39, si bien qu'a chacun des incréments successifs, l'appareil affiche s'il y a connexion ou non avec le plan de masse ou une quelconque autre pastille de la rangée.

Le dispositif selon l'invention permet donc :
- de tester rapidement un circuit imprimé multicouches 24, 25 ;
- de localiser rangée par rangée, à la fois la position et la nature de l'incident ;
- d'effectuer ce contrôle avec un appareillage 35, 38, 39 standard, seul le circuit palpeur 26 étant spécifique du type de circuit 24, 25 à tester.

Bien entendu, on ne quitterait pas le cadre de l'invention en modifiant le mode de réalisation de l'appareillage palpeur général qui peut se présenter sous des formes diverses (circuit 35, languettes, circuit imprimé, etc...).

Par ailleurs, les données standard pour un circuit réputé "BON" peuvent être entrées dans la mémoire 39 suivant tout procédé connu. Par exemple il peut s'agir de paramètres préalablement lus sur un circuit standard. Il peut aussi s'agir de données directement fournies par la CAO ("conception assistée par ordinateur").

De même, l'avacement du circuit explorateur 35 par incréments successifs peut être programmé en fonction des grilles utilisées pour l'implantation du circuit 24 ou 25.

## Revendications

1 - Procédé d'exploitation pour la vérification et le contrôle en fabrication d'un circuit imprimé comportant des pastilles conductrices de contrôle, caractérisé en ce qu'on
- explore ce circuit imprimé (24), (25) muni d'un circuit d'interface spécifique ou circuit palpeur (26) possédant des plots conducteurs (30) à (34) ;
- circuit palpeur (26) sur lequel on déplace par incréments un circuit explorateur (35) standard, relié par ailleurs à un montage électronique mesurant et mémorisant à chaque incrément les isolement et conductivités sous forme de paramètres qui sont ensuite comparés avec les paramètres précédemment mis en mémoire d'un circuit réputé "BON".

2 - Dispositif de contrôle pour la mise en oeuvre du procédé suivant la revendication 1, caractérisé en ce qu'il comprend, en combinaison :

- un circuit palpeur spécifique (26), constitué par une plaque d'un matériau isolant souple (27), pourvue sur ses deux faces (28) et (29) d'une pluralité de plots conducteurs (30), (31),...(34), dont le nombre et la position correspondent à toutes les pastilles conductrices utiles (2), (4),...(10) de chacun des arbres accessibles par une des faces (12) du circuit à contrôler (24), (25), la liaison électrique entre chaque couple de plots conducteurs (30)...(34) qui correspond à une pastille (2),...(10) du circuit à contrôler (24), (25) étant assurée par un trou métallisé (40) ;

- un circuit explorateur (35), associé au circuit palpeur (26), et constitué par un film souple isolant (25), comportant sur une de ses faces (36), une plage conductrice (37) dont les dimensions sont suffisantes pour lui permettre de recouvrir en totalité la surface du circuit à contrôler (24), (25), alors qu'est prévue une rangée de plots conducteurs (41),...(43) à diamètre (44) plus faible que le plus faible espace isolant (45) qui peut se trouver entre deux plots contigus (31), (32) sur la face externe (12) du circuit palpeur spécifique (26), les dits plots (41), (42), (43) étant reliés à l'électronique de détection (38) par une nappe de pistes conductrices réalisées sur l'une des faces du circuit explorateur (35), le pas (46) des plots (41), (42), (43) et leur nombre étant tels que la longueur (47) de la rangée de plots (41), (42), (43) est supérieure à la plus petite dimension (48) du circuit à contrôler (24), (25) tandis que toutes les pastilles (2), (4),...(10) d'une rangée sont en contact avec les plots (41), (42), (42) ;

- un système électronique de détection (38) et une mémoire (39) permettant, par un procédé de multiplexage, d'enregistrer l'état de conduction électrique de chaque plots (41), (42), (43) par rapport à la plage conductrice (37), et à chacun des autres plots (41), (42), (43) de la rangée au moment de la mesure, et les coordonnées de position de chacun des plots.

3 - Dispositif suivant la revendication 2, caractérisé en ce que la géométrie du circuit palpeur spécifique (26) assurant l'interface comporte tous les plots (30) à (34) correspondant aux pastilles utiles (2) à (11).

4 - Dispositif suivant l'une quelconque des revendications 2 et 3, caractérisé en ce qu'il comporte un seul appareillage explorateur standard (35), (38), (39), utilisable pour divers types de circuit (24), (25), et un seul interface constitué par le circuit palpeur (26) spécifique pour chaque type de circuit (24), (25) à contrôler.

5 - Procédé suivant la revendication 1, caractérisé en ce que l'avancement du circuit explorateur (35) par des incréments successifs est programmé en fonction des grilles utilisées pour l'implantation du circuit (24), (25).

6 - Procédé suivant l'une quelconque des revendications 1 et 5, caractérisé en ce qu'on met en mémoir (39) des paramètres standard réputés "BONS" fournis directement par la CAO (conception assistée par ordinateur).

Fig-1

Fig-2

Fig. 3

Fig. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 590 439 (TERADYNE)<br>* figure 1; page 4, ligne 1 - page 5, ligne 5; page 6, ligne 20 - page 9, ligne 19 *<br>--- | 1-6 | H 05 K 13/08 |
| A | DE-A-3 104 227 (ATG)<br>* figure 1; page 6, ligne 27 - page 8, ligne 8 *<br>--- | 1-6 | |
| A | FR-A-2 498 335 (EVERETT-CHARLES)<br>* figures 1,4,5; page 17, ligne 2 - page 19, ligne 20 *<br>----- | 1,2 | |

**DOMAINES TECHNIQUES RECHERCHES (Int. Cl.4)**

H 05 K 13/08
H 01 R 11/18
H 01 R 13/24
H 05 K 3/46

Le présent rapport a été établi pour toutes les revendications

| Lieu de la recherche | Date d'achèvement de la recherche | Examinateur |
|---|---|---|
| BERLIN | 28-06-1989 | HAHN G |